# EUROPÄISCHE PATENTSCHRIFT

(11) **EP 1 098 436 B1**
(45) Veröffentlichungstag und Bekanntmachung des Hinweises auf die Patenterteilung: **14.02.2007**
(21) Anmeldenummer: 00122212.4
(22) Anmeldetag: 16.10.2000
(51) Int. Cl.: H03F 3/217

(54) **Verfahren zur Ansteuerung eines Audioverstärkers und Audioverstärker mit einer getakteten Endstufe**
Method for controlling an audio amplifier and audio amplifier with a switched output stage
Procédé pour commander un amplificateur audio et amplificateur audio à un étage de sortie commuté

(30) Priorität: 04.11.1999 DE 19953119
(43) Veröffentlichungstag der Anmeldung: 09.05.2001
(73) Patentinhaber: Harman Becker Automotive Systems GmbH, 76307 Karlsbad (DE)
(72) Erfinder: Pfaffinger, Gerhard, Dipl.-Ing., 93055 Regensburg (DE); Schreiber, Siegmung, Dipl.-Ing. (FH), 93055 Regensburg (DE)
(74) Vertreter: Patentanwälte Westphal, Mussgnug & Partner

(56) Entgegenhaltungen:
- EP-A- 0 543 224
- DE-A1- 3 716 826
- US-A- 3 568 094
- US-A- 4 300 022
- US-A- 4 360 707
- PATENT ABSTRACTS OF JAPAN Bd. 007, Nr. 072 (E-166), 25. März 1983 (1983-03-25) & JP 58 003392 A (PIONEER KK), 10. Januar 1983 (1983-01-10)

## Beschreibung

Die Erfindung betrifft einen Audioverstärker mit einer getakteten Endstufe und mit einem angeschlossenen Lautsprecher.

Weil in einem Kraftfahrzeug die von der Autobatterie oder von der Lichtmaschine gelieferte Spannung maximal 14,4 V beträgt, ist die am Lautsprecher einer Audioanlage verfügbare Leistung nach oben hin beschränkt. Um die Leistung am Lautsprecher zu erhöhen, sind zwei Maßnahmen möglich. Die erste Maßnahme sieht vor, den Widerstand des Lautsprechers zu verringern, während die zweite auf einer Erhöhung der Versorgungsspannung beruht.

Die DE 37 16 826 A1 offenbart hierzu einen Audioverstärker mit einer getakteten Endstufe und mit einem angeschlossenen Lautsprecher, wobei die erste Spule einer Doppelspule des Lautsprechers von einem ersten Schaltnetzteil bestromt wird, die zweite Spule einer Doppelspule des Lautsprechers von einem zweiten Schaltnetzteil bestromt wird und die Steuersignale für die Schaltnetzteile von einem Audiosignal moduliert werden.

Es ist demgegenüber Aufgabe der Erfindung, die versorgungsspannung für eine Audioanlage, insbesondere in einem Kraftfahrzeug, mit möglichst wenigen, einfachen Mitteln zu erhöhen.

Die Erfindung löst diese Aufgabe bei einem Audioverstärker mit einer getakteten Endstufe und mit einem angeschlossenen Lautsprecher dadurch, dass eine Versorgungsgleichspannungsquelle an eine Brückenschaltung angeschlossen ist, in deren ersten Zweig ein erstes Schaltnetzteil aus einer ersten Induktivität und einem ersten dazu in Reihe geschalteten Schalttransistor liegt, in deren zweitem Zweig ein zweites Schaltnetzteil aus einer zweiten Induktivität und einem zweiten dazu in Reihe geschalteten Schalttransistor liegt, dass im Querzweig der Brückenschaltung zwei entgegengesetzt gepolte in Reihe geschaltete Dioden liegen, dass der Mittelabgriff des Querzweiges - der gemeinsame Verbindungspunkt der beiden Dioden - über eine Kapazität mit dem ersten Pol der Versorgungsgleichspannungsquelle verbunden ist, dass der Lautsprecher mit einer Doppelspule an die Elektroden der beiden Dioden angeschlossen ist und dass der Steuereingang des ersten Schalttransistors mit einem ersten Signalprozessor und der Steuereingang des zweiten Schalttransistors mit einem zweiten Signalprozessor verbunden ist.

Beim erfindungsgemäßen Audioverstärker führen die beiden Schaltnetzteile eine Doppelfunktion aus. Die erste Funktion liegt darin, dass das pulsweitenmodulierte Signal, das an den Steuereingängen der beiden Schaltneztteile liegt, eine Erhöhung der Spannung am Lautsprecher bewirkt. Weil aber das pulsweitenmodulierte Signal von einem Audiosignal moduliert ist, ist in der Pulsweite des pulsweitenmodulierten Signals das Audiosignal enthalten. Dadurch, dass das pulsweitenmodulierte Signal an den Lautsprecher gelegt wird und der Lautsprecher als Tiefpass wirkt, wandelt er das vom Audiosignal modulierte pulsweitenmodulierte Signal in akustische Signale. Die zweite Funktion der beiden Schaltnetzteile liegt deshalb darin, das elektrische Audiosignal für den Lautsprecher zu liefern. Das pulsweitenmodulierte Signal der beiden Schaltnetzteile bewirkt einerseits eine Erhöhung der Spannung am Lautsprecher und stellt andererseits gleichzeitig das elektrische Audiosignal für den Lautsprecher dar. Das erste Schaltnetzteil wird von den positiven Abtastwerten eines analogen Audiosignals moduliert, während die negativen Abtastwerte des analogen Audiosignales das zweite Schaltnetzteil modulieren.

Der erfindungsgemäße Audioverstärker wird nun anhand der Figuren beschrieben und erläutert.

In der Zeichnung zeigen:
- Figur 1: ein Ausführungsbeispiel des erfindungsgemäßen Audioverstärkers,
- Figur 2: ein Spannungsdiagramm für ein erstes Pulsweitenverhältnis und
- Figur 3: ein Spannungsdiagramm für ein zweites Pulsweitenverhältnis.

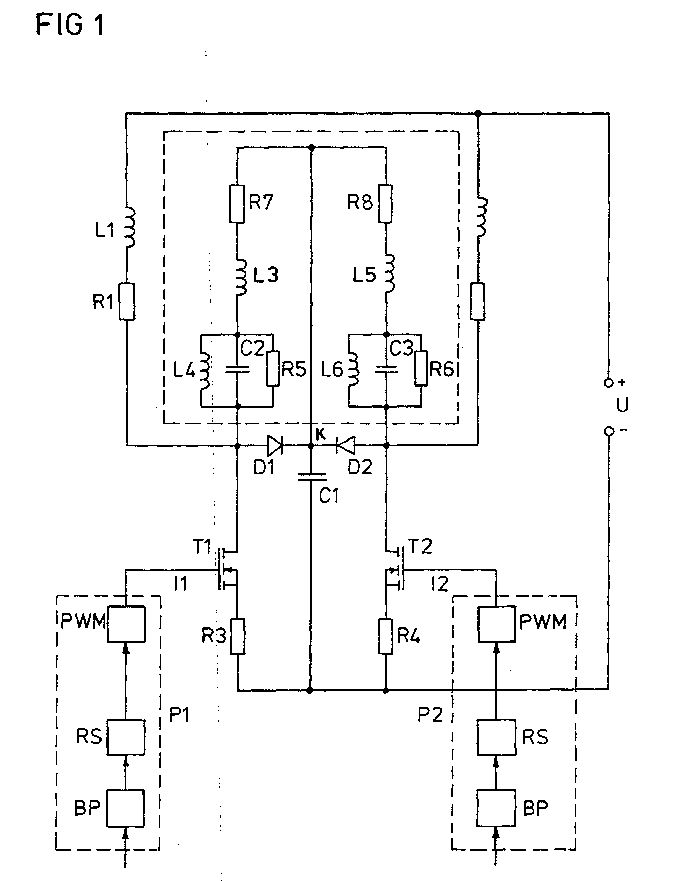

Bei dem in der Figur 1 gezeigten Ausführungsbeispiel eines erfindungsgemäßen Audioverstärkers ist der Pluspol einer Versorgungsspannungsquelle U an den ersten Anschluss und der Minuspol der Versorgungsspannungsquelle U an den zweiten Anschluss einer Brückenschaltung angeschlossen, in deren erstem Zweig eine Induktivität L1, ein Widerstand R1, die Streckenelektroden eines Schalttransistors T1 und ein Widerstand R3 in Reihe liegen und in deren zweitem Zweig eine Induktivität L2, ein Widerstand R2, ein Schalttransistor T2 und ein Widerstand R4 in Reihe liegen. Im Querzweig der Brückenschaltung liegen zwei entgegengesetzt gepolte Dioden D1 und D2 in Reihe. Der Mittelabgriff des Querzweiges - der gemeinsame Verbindungspunkt K der beiden Dioden D1 und D2 - ist über eine Kapazität C1 mit dem zweiten Anschluss der Brückenschaltung bzw. mit dem Minuspol der Versorgungsspannungsquelle U verbunden. An die Elektroden der beiden Dioden D1 und D2 ist ein Lautsprecher LS mit einer Doppelspule aus zwei Spulen L3 und L5 angeschlossen. In der Figur 1 ist die elektrische Nachbildung des Lautsprechers LS mit der Doppelspule im Einzelnen gezeigt.

Parallel zur Diode D1 liegt eine Reihenschaltung aus einer Parallelschaltung, die aus einer Induktivität L4, einer Kapazität C2 und einem Widerstand R5 aufgebaut ist, aus einer Induktivität L3 und aus einem Widerstand R7, während parallel zur Diode D2 eine Reihenschaltung gleichen Aufbaus aus einer Parallelschaltung, die aus einer Induktivität L6, einer Kapazität C3 und einem Widerstand R6 aufgebaut ist, aus einer Induktivität L5 und aus einem Widerstand R8 liegt. Die beiden Induktivitäten L3 und L5 sind die beiden Spulen der Doppelspule des Lautsprechers LS. Die Widerstände R7 und R8 stellen den Ohm'schen Widerstand des Lautsprechers LS dar und die beiden Parallelschaltungen aus der Induktivität L4, der Kapazität C2 und dem Widerstand R5 sowie aus der Induktivität L6, der Kapazität C3 und dem Widerstand R6 stellen die Impedanz des Lautsprechers LS dar.

An die Steuerelektrode des Schalttransistors T1 ist ein digitaler Signalprozessor P1 und an die Steuerelektrode des Schalttransistors T2 ein digitaler Signalprozessor P2 angeschlossen, an deren Eingängen ein analoges oder digitales Audiosignal A liegt. Die beiden digitalen Signalprozessoren P1 und P2 können z.B. aus einem Bandpass BP, einer Rauschsperre RS und einem Pulsweitenmodulator PWM aufgebaut sein.

Die Steuerelektroden der beiden Schalttransistoren T1 und T2 können beispielsweise über je eine digitale Signalleitung I1 bzw. I2, zum Beispiel ein I²S-Bus, mit dem digitalen Signalprozessor P1 bzw. P2 verbunden sein.

Vorzugsweise sind für die Schalttransistoren T1 und T2 MOS-Feldeffekttransistoren vorgesehen.

Es wird nun die Funktion des in der Figur 1 gezeigten Ausführungsbeispieles eines erfindungsgemäßen Audioverstärkers erläutert.

Der digitale Signalprozessor P1 erzeugt ein pulsweitenmoduliertes Steuersignal für den Schalttransistor T1, das von den positiven Abtastwerten des Audiosignales moduliert wird, während der Signalprozessor P2 ein pulsweitenmoduliertes Steuersignal für den Schalttransistor T2 liefert, das von den negativen Abtastwerten des Audiosignales moduliert wird. Weil das Steuersignal für den Schalttransistor T1 von den positiven Abtastwerten, das Steuersignal für den Schalttransistor T2 dagegen von den negativen Abtastwerten des Audiosignales moduliert wird, arbeiten die beiden Schalttransistoren T1 und T2 im Gegentakt.

Der gemeinsame Verbindungspunkt der beiden Dioden D1 und D2, der beiden Widerstände R7 und R8 sowie der Kapazität C1, der als Knoten K bezeichnet ist, liegt wegen der beiden Dioden D1 und D2 stets auf einem Potential, das wegen der beiden Schaltnetzteile größer als +U ist.

Bei geschlossenem Schalttransistor T1 und geöffnetem Schalttransistor T2 führt ein erster Strompfad vom Pluspol der Versorgungsspannungsquelle U über die Induktivität L1, den Widerstand R1, den Transistor T1 und den Widerstand R3 zum Minuspol der Versorgungsspannungsquelle U. Ein zweiter Strompfad, der Pfad für das Audiosignal, führt vom Pluspol der Versorgungsspannungsquelle U über die Induktivität L2, den Widerstand R2, die Diode D2 zum Knoten K und von dort über den Widerstand R7, die Spule L3 und die Parallelschaltung aus der Induktivität L4, der Kapazität C2 und des Widerstandes R5 des Lautsprechers LS zum Transistor T1 und von dort über den Widerstand R3 zum Minuspol der Versorgungsspannungsquelle U. Analog dazu führt bei geschlossenem Schalttransistor T2 und geöffnetem Schalttransistor T2 ein erster Strompfad vom Pluspol der Versorgungsspannungsquelle U über die Induktivität L2, den Widerstand R2, den Transistor T2 und den Widerstand R4 zum Minuspol der Versorgungsspannungsquelle U. Ein zweiter Strompfad, der Pfad für das Audiosignal, führt vom Pluspol der Versorgungsspannungsquelle U über die Induktivität L1, den Widerstand R1, die Diode D1 zum Knoten K und von dort über den Widerstand R8, die Spule L5 und die Parallelschaltung aus der Induktivität L6, der Kapazität C3 und dem Widerstand R6 des Lautsprechers LS zum Transistor T2 und von dort über den Widerstand R4 zum Minuspol der Versorgungsspannungsquelle U.

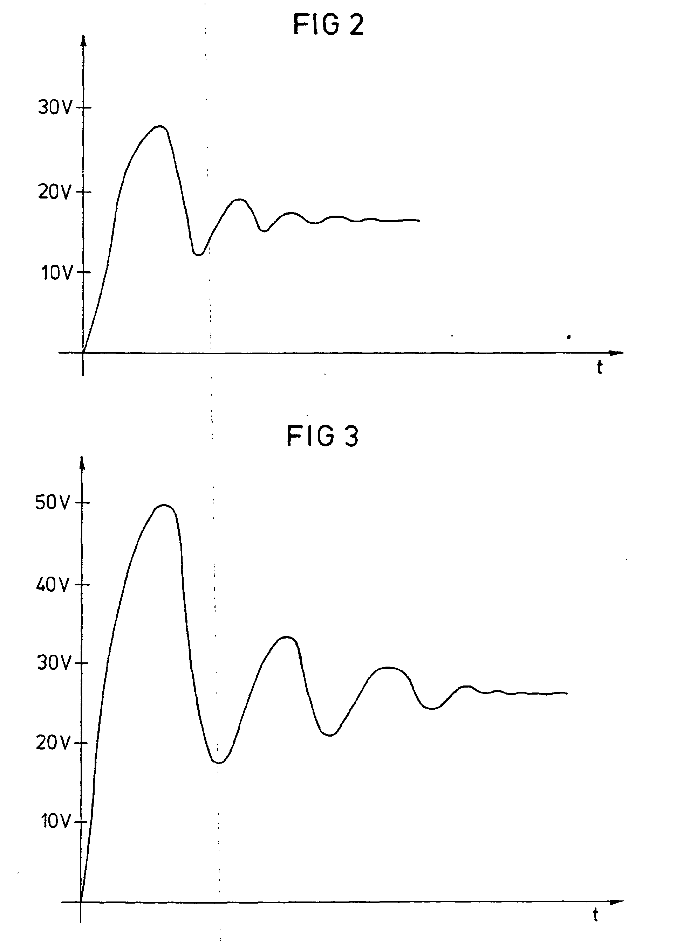

Mittels der beiden Induktivitäten L1 und L2 wird die Erhöhung der Spannung am Knoten K erzielt. In der Fig. 2 ist die Spannung am Knoten K für ein Tastverhältnis von 1%, in der Fig. 3 für ein Tastverhältnis von 50% gezeigt, wo sich die Spannung auf einen Endwert von etwa 26 V einschwingt.

Durch die Maßnahme, einen Lautsprecher mit einer Doppelspule aus zwei Spulen vorzusehen, ergeben sich die folgenden Vorteile.

Anstatt von vier Schalttransistoren bei einer Pulsweitenmodulationvollbrücke genügen bei der Erfindung zwei Schalttransistoren. Zur Durchsteuerung der beiden Schalttransistoren wird keine Spannung erzeugt, die größer ist als die Versorgungsspannung U. Bei einem Kurzschluss fließt der Kurzschlussstrom mindestens durch eine der Spulen des Lautsprechers. Schaltverzögerungen bei den Schalttransistoren wirken sich nur geringfügig aus.

Während beim Stand der Technik an einem Lautsprecher mit einem Widerstand von 2 Ohm eine Leistung von etwa 40 W möglich ist, erreicht die Erfindung an einem Lautsprecher mit einem Widerstand von 2 Ohm bereits eine Leistung von etwa 150 W.

### Bezugszeichenliste

- A: Audiosignal
- C1: Kapazität
- C2: Kapazität
- C3: Kapazität
- D1: Diode
- D2: Diode
- L1: Induktivität
- L2: Induktivität
- L3: Spule des Lautsprechers
- L4: Induktivität
- L5: Spule des Lautsprechers
- L6: Induktivität
- LS: Lautsprecher
- R1 - R8: Widerstand
- P1: digitaler Signalprozessor
- P2.: digitaler Signalprozessor
- PWM: Pulsweitenmodulator
- RS: Rauschsperre
- BP: Bandpass
- T1: Schalttransistor
- T2: Schalttransistor
- K: Knoten
- I1: digitale Signalleitung
- I2,: digitale Signalleitung

## Patentansprüche

1. Audioverstärker mit einer getakteten Endstufe und einem angeschlossenem Lautsprecher (LS),bei dem eine Versorgungsgleichspannung (U) an eine Brückenschaltung angeschlossen ist, in deren erstem Zweig eine erste Reihenschaltung aus einer ersten Induktivität (L1) und einem ersten Schalttransistor (T1) liegt, in deren zweitem Zweig eine zweite Reihenschaltung aus einer zweiten Induktivität (L2) und einem zweiten Schalttransistor (T2) liegt,
**dadurch gekennzeichnet,**
**dass** im Querzweig der Brückenschaltung zwei in Reihe geschaltete entgegengesetzt gepolte Dioden (D1, D2) liegen, dass der Mittelabgriff des Querzweiges - der gemeinsame Knoten (K) der beiden Dioden (D1, D2) - über eine erste Kapazität (C1) mit dem einen Pol der Versorgungsgleichspannungsquelle (U) verbunden ist,
**dass** ein Lautsprecher (LS) mit einer Doppelspule (L3, L5) an die Elektroden der beiden Dioden (D1, D2) angeschlossen ist und
**dass** der Steuereingang des ersten Schalttransistors (T1) mit dem Ausgang eines ersten digitalen Signalprozessors (P1) und der Steuereingang des zweiten Schalttranistors (T2) mit dem Ausgang eines zweiten digitalen Signalprozessors (P2) verbunden ist.

2. Audioverstärker nach Anspruch 1,
**dadurch gekennzeichnet, dass** im ersten Zweig und im zweiten Zweig der Brückenschaltung zwischen der ersten und der zweiten Induktivität (L1, L2) und dem Querzweig je ein erster und ein zweiter Widerstand (R1, R2) liegen.

3. Audioverstärker nach Anspruch 1 oder 2,
**dadurch gekennzeichnet, dass** im ersten und im zweiten Zweig der Brückenschaltung zwischen dem ersten Schalttransistor (T1) und dem einen Pol der Versorgungsgleichspannungsquelle (U) ein dritter Widerstand (R3) liegt und dass zwischen dem zweiten Schalttransistor (T2) und dem einen Pol der Versorgungsgleichspannungsquelle (U) ein vierter Widerstand (R4) liegt.

4. Audioverstärker nach Anspruch 1, 2 oder 3,
**dadurch gekennzeichnet, dass** die Schalttransistoren (T1, T2) MOS-Feldeffekttransistoren sind.

5. Audioverstärker nach einem der Ansprüche 1 bis 4,
**dadurch gekennzeichnet, dass** der gemeinsame Anschluss der beiden Spulen (L3, L5) des Lautsprechers (LS) an den Mittelabgriff des Querzweiges - den Knoten (K) - angeschlossen ist, dass der andere Anschluss der einen Spule (L3) des Lautsprechers (LS) an das eine Ende und der andere Anschluss der anderen Spule (L5) des Lautsprechers (LS) an das andere Ende des Querzweiges angeschlossen ist.

6. Audioverstärker nach einem Ansprüche 1 bis 5,
**dadurch gekennzeichnet, dass** das Audiosignal am Eingang eines Abtasters liegt, dessen Ausgang an den Eingang des ersten und des zweiten digitalen Signalprozessors (P1, P2) angeschlossen ist.

7. Audioverstärker nach einem der Ansprüche 1 bis 6,
**dadurch gekennzeichnet, dass** der Ausgang des ersten digitalen Signalprozessors (P1) über eine erste digitale Leitung (I1) mit der Steuerelektrode des ersten Schalttransistors (T1) und der Ausgang des zweiten digitalen Signalprozessors (P2) über eine zweite digitale Signalleitung (I2) mit der Steuerelektrodes des zweiten Schalttransistors (T2) verbunden ist.

8. Audioverstärker nach Anspruch 7,
**dadurch gekennzeichnet, dass** für die digitalen Signalleitungen (I1, I2) je ein I²S-Bus vorgesehen ist.

9. Audioverstärker nach einem der Ansprüche 1 bis 8,
**dadurch gekennzeichnet, dass** jeder digitale Signalprozessor (P1,P2) aus einem Bandpass (BP), einer Rauschsperre (RS) und einem Pulsweitenmodulator (PWM) aufgebaut ist.

10. Audioverstärker nach einem der Ansprüche 1 bis 9,
**dadurch gekennzeichnet, dass** der Audioverstärker an das Bordnetz eines Fahrzeuges angeschlossen ist.

## Claims

1. An audio amplifier with a switched output stage and a connected loudspeaker (LS), in which a DC supply voltage (U) is connected to a bridge circuit, situated in the first branch of which there is a first series circuit comprising a first inductance (L1) and a first switching transistor (T1) and in whose second branch there is a second series circuit comprising a second inductance (L2) and a second switching transistor (T2), **characterised in that** situated in the transverse branch of the bridge circuit there are two series connected, oppositely poled diodes (D1, D2), that the centre tapping of the transverse branch - the common node (K) of the two diodes (D1, D2) - is connected via a first capacitance (C1) to one pole of the DC supply voltage source (U), that a loudspeaker (LS) with a double coil (L3, L5) is connected to the electrodes of the two diodes (D1, D2) and that the control input of the first switching transistor (T1) is connected to the output of a first digital signal processor (P1) and the control input of the second switching transistor (T2) is connected to the output of a second digital signal processor (P2).

2. An audio amplifier as claimed in Claim 1, **characterised in that** situated in the first branch and in the second branch of the bridge circuit between the first and second inductance (L1, L2) and the transverse branch there is a respective first and second resistor (R1, R2).

3. An audio amplifier as claimed in Claim 1 or 2, **characterised in that** situated in the first and the second branch of the bridge circuit between the first switching transistor (T1) and the one pole of the DC supply voltage source (U) there is a third resistor (R3) and that between the second switching transistor (T2) and the one pole of the DC supply voltage source (U) there is a fourth resistor (R4).

4. An audio amplifier as claimed in Claim 1, 2 or 3, **characterised in that** the switching transistors (T1, T2) are MOS field effect transistors.

5. An audio amplifier as claimed in one of Claims 1 to 4, **characterised in that** the common connection of the two coils (L3, L5) of the loudspeaker (LS) is connected to the centre tapping of the transverse branch - the node (K) -, that the other connection of the one coil (L3) of the loudspeaker (LS) is connected to one end of the transverse branch and the other connection of the other coil (L5) of the loudspeaker (LS) is connected to the other end of the transverse branch.

6. An audio amplifier as claimed in one of Claims 1 to 5, **characterised in that** the audio signal is present at the input of a scanner, the output of which is connected to the input of the first and second digital processors (P1, P2).

7. An audio amplifier as claimed in one of Claims 1 to 6, **characterised in that** the output of the first digital signal processor (P1) is connected via a first digital line (I1) to the control electrode of the first switching transistor (T1) and the output of the second digital signal processor (P2) is connected via a second digital signal line (I2) to the control electrode of the second switching transistor (T2).

8. An audio amplifier as claimed in Claim 7, **characterised in that** a respective I²S bus is provided for the digital signal lines (I1, I2).

9. An audio amplifier as claimed in one of Claims 1 to 8, **characterised in that** each digital signal processor (P1, P2) is composed of a band-pass filter (BP), a squelch circuit (RS) and a pulse width modulator (PWM).

10. An audio amplifier as claimed in one of Claims 1 to 9, **characterised in that** the audio amplifier is connected to the onboard network of a vehicle.

## Revendications

1. Amplificateur audio comprenant un étage final synchronisé et un haut-parleur (LS) raccordé, dans lequel une tension continue d'alimentation (U) est raccordée à un circuit en pont, dans la première branche duquel est disposé un premier montage en série constitué d'une première inductance (L1) et d'un premier transistor de commutation (T1), dans la seconde branche duquel est disposé un second montage en série constitué d'une seconde inductance (L2) et d'un second transistor de commutation (T2),
**caractérisé en ce que**
deux diodes (D1, D2) montées en série et polarisées dans le sens opposé sont disposées dans la branche transversale du circuit en pont, **en ce que** la prise centrale de la branche transversale, le noeud (K) commun des deux diodes (D1, D2), est reliée au moyen d'une première capacité (C1) à un pôle de la source de tension continue d'alimentation (U),
**en ce qu'**un haut-parleur (LS) est raccordé par une double bobine (L3, L5) aux électrodes des secondes diodes (D1, D2) et
**en ce que** l'entrée de commande du premier transistor de commutation (T1) est reliée à la sortie d'un premier processeur de signaux numériques (P1) et l'entrée de commande du second transistor de commutation (T2) est reliée à la sortie d'un second processeur de signaux numériques (P2).

2. Amplificateur audio selon la revendication 1,
**caractérisé en ce que**, à chaque fois, une première et une seconde résistances (R1, R2) sont disposées dans la première branche et la seconde branche du circuit en pont entre la première et la seconde inductances (L1, L2) et la branche transversale.

3. Amplificateur audio selon la revendication 1 ou 2,
**caractérisé en ce qu'**une troisième résistance (R3) est disposée dans la première et la seconde branches du circuit en pont entre le premier transistor de commutation (T1) et un pôle de la source de tension continue d'alimentation (U) et **en ce qu'**une quatrième résistance (R4) est disposée entre le second transistor de commutation (T2) et un pôle de la source de tension continue d'alimentation (U).

4. Amplificateur audio selon la revendication 1, 2 ou 3,
**caractérisé en ce que** les transistors de commutation (T1, T2) sont des transistors à effet de champ MOS.

5. Amplificateur audio selon l'une quelconque des revendications 1 à 4,
**caractérisé en ce que** le raccordement commun des deux bobines (L3, L5) du haut-parleur (LS) est raccordé à la prise centrale de la branche transversale, le noeud (K), **en ce que** l'autre raccordement de la bobine (L3) du haut-parleur (LS) est raccordé à une des extrémités de la branche transversale et l'autre raccordement de l'autre bobine (L5) est raccordé du haut-parleur (LS) à l'autre extrémité de la branche transversale.

6. Amplificateur audio selon l'une quelconque des revendications 1 à 5,
**caractérisé en ce que** le signal audio est situé sur l'entrée d'un échantillonneur, dont la sortie est raccordée à l'entrée du premier et du second processeurs de signaux numériques (P1, P2).

7. Amplificateur audio selon l'une quelconque des revendications 1 à 6,
**caractérisé en ce que** la sortie du premier processeur de signaux numériques (P1) est reliée par une première ligne (I1) numérique à l'électrode de commande du premier transistor de commutation (T1) et la sortie du second processeur de signaux numériques (P2) est reliée par une seconde ligne de signal numérique (12) à l'électrode de commande du second transistor de commutation (T2).

8. Amplificateur audio selon la revendication 7,
**caractérisé en ce que**, à chaque fois, un bus I²S est prévu pour les lignes de signal numériques (I1, I2).

9. Amplificateur audio selon l'une quelconque des revendications 1 à 8,
**caractérisé en ce que** chaque processeur de signaux numériques (P1, P2) est construit à partir d'un passe-bande (BP), d'un silencieux de bruit (RS) et d'un modulateur d'impulsion en largeur (PWM).

10. Amplificateur audio selon l'une quelconque des revendications 1 à 9,
**caractérisé en ce que** l'amplificateur audio est raccordé au réseau de bord d'un véhicule.
